# EUROPÄISCHE PATENTANMELDUNG

(11) **EP 2 966 269 A1**
(43) Veröffentlichungstag der Anmeldung: **13.01.2016**
(21) Anmeldenummer: 15175576.6
(22) Anmeldetag: 07.07.2015
(51) Int. Cl.: F01D 17/16, F04D 29/56, F03B 3/18, C23C 4/00, C23C 28/00

(54) **VERSCHLEISSSCHUTZANORDNUNG FÜR EINE STRÖMUNGSMASCHINE, VERFAHREN UND VERDICHTER**

(30) Priorität: 08.07.2014 DE 102014213263
(71) Anmelder: MTU Aero Engines AG, 80995 München (DE)
(72) Erfinder: Schneiderbanger, Stefan, 85221 Dachau (DE); Albers, Lothar, 80638 München (DE); Bock, Stephan, Dr., 82140 Olching (DE)

(57) **Zusammenfassung**

Die vorliegende Erfindung betrifft eine Verschleißschutzanordnung für eine Strömungsmaschine, umfassend wenigstens eine verstellbare Leitschaufel (1), ein Gehäuse (5), in dem die wenigstens eine Leitschaufel (1) verstellbar angeordnet ist, einen aus einem metallischen Material hergestellten Innenring (9), in oder an dem die wenigstens eine Leitschaufel (1) verstellbar angeordnet ist, einen ersten Spalt (31) zwischen einer inneren Leitschaufelfahne (25) und dem Innenring (9) und einen zweiten Spalt (33) zwischen einer äußeren Leitschaufelfahne (17) und dem Gehäuse (5), wenigstens eine Verschleißschutzschicht (27), wobei die Verschleißschutzschicht(en) (27) mit dem Innenring (9) und/oder mit der inneren Leitschaufelfahne (25) verbunden ist oder sind und die Verschleißschutzschicht(en) (27) den ersten Spalt (31) zumindest bereichsweise ausbildet oder ausbilden, und/oder die Verschleißschutzschicht(en) (27) mit dem Gehäuse (9) und/oder mit der äußeren Leitschaufelfahne (17) verbunden ist oder sind und die Verschleißschutzschicht(en) (27) den zweiten Spalt (33) zumindest bereichsweise ausbildet oder ausbilden. Ferner betrifft die Erfindung ein Verfahren zum Aufbringen einer zerreibbaren Verschleißschutzschicht (27), ein Verfahren zum Aufbringen einer schleifenden Verschleißschutzschicht (27) sowie einen Verdichter einer Strömungsmaschine mit wenigstens einer Verschleißschutzanordnung.

## Beschreibung

Die vorliegende Erfindung betrifft eine Verschleißschutzanordnung für eine Strömungsmaschine gemäß dem Oberbegriff des Anspruchs 1. Des Weiteren betrifft die vorliegende Erfindung ein Verfahren gemäß Anspruch 12, ein weiteres Verfahren gemäß Anspruch 13 sowie einen Verdichter gemäß Anspruch 14.

In Strömungsmaschinen können zur Volumenstromregelung verstellbare Leitschaufeln eingesetzt werden. Die Leitschaufeln werden in der Regel im Gehäuse der Strömungsmaschine und in Innenringen der Leiträder verstellbar gelagert. Hinsichtlich einer Wirkungsgradoptimierung sollten die Spalte zwischen den Leitschaufelfahnen, also den radial inneren und äußeren Schaufelenden, und dem Gehäuse bzw. dem Innenring klein gehalten werden. Bei kleinen Spalten und möglichen großen Verstellwinkeln der Leitschaufeln besteht jedoch die Gefahr eines Berührens oder Schleifens der Schaufelfahnen an den Oberflächen des Gehäuses oder des Innenrings. Ein Kontakt der Schaufelfahnen an den Oberflächen des Gehäuses oder des Innenrings kann jedoch auch durch einen Verschleiß der Leitschaufellagerung im Gehäuse und/ oder im Innenring bedingt oder verursacht sein. Weiterhin können sogenannte Ovalitäten zu derartigen Berührungen oder schleifenden Kontakten, im Folgenden kurz als Beschädigungen bezeichnet, führen. Ovalitäten können durch Unrundheiten der Leitschaufellagerungen in dem Gehäuse oder im Innenring, beispielsweise fertigungsbedingt, verursacht sein. Ovalitäten an Innenringen und/ oder an Gehäusen können jedoch auch beispielsweise durch thermische Effekte oder Druckkräfte verursacht sein. Diese Beschädigungen können dazu führen, dass diese Bauteile repariert oder ausgetauscht werden müssen, was wiederum längere Ausfallzeiten und hohe Reparaturkosten bedeuten kann.

Eine Aufgabe der vorliegenden Erfindung ist es, eine Anordnung für Strömungsmaschinen vorzuschlagen, die längere Ausfallzeiten und hohe Reparaturkosten bei Beschädigungen der oben beschriebenen Art vermeiden. Ferner ist es Aufgabe der vorliegenden Erfindung, ein Verfahren zum Aufbringen einer zerreibbaren Verschleißschutzschicht sowie ein Verfahren zum Aufbringen einer schleifenden Verschleißschutzschicht vorzuschlagen. Weiterhin ist es Aufgabe der vorliegenden Erfindung einen Verdichter einer Strömungsmaschine vorzuschlagen.

Die erfindungsgemäße Aufgabe wird durch eine Verschleißschutzanordnung mit den Merkmalen des Anspruchs 1 gelöst. Sie wird ferner durch ein Verfahren mit den Merkmalen des Anspruchs 12, ein Verfahren mit den Merkmalen des Anspruchs 13 sowie einen Verdichter mit den Merkmalen des Anspruchs 14 gelöst.

Erfindungsgemäß wird somit eine Verschleißschutzanordnung für eine Strömungsmaschine mit wenigstens einer verstellbaren Leitschaufel vorgeschlagen. Die Verschleißschutzanordnung umfasst ein Gehäuse, in dem die wenigstens eine Leitschaufel verstellbar angeordnet ist. Weiterhin umfasst die Verschleißschutzanordnung einen aus einem metallischen Material hergestellten Innenring.

Die erfindungsgemäße Verschleißschutzanordnung umfasst weiterhin einen ersten Spalt zwischen einer inneren Leitschaufelfahne und dem Innenring, sowie einen zweiten Spalt zwischen einer äußeren Leitschaufelfahne und dem Gehäuse.

Die erfindungsgemäße Verschleißschutzanordnung umfasst gleichfalls wenigstens eine Verschleißschutzschicht. Die wenigstens eine Verschleißschutzschicht ist mit dem Innenring oder mit der inneren Leitschaufelfahne verbunden. Alternativ ist wenigstens eine Verschleißschutzschicht mit dem Innenring und wenigstens eine weitere Verschleißschutzschicht mit der inneren Leitschaufelfahne verbunden. Die eine oder mehrere Verschleißschutzschicht(en) bildet oder bilden den ersten Spalt zumindest bereichsweise aus.

Die erfindungsgemäße Verschleißschutzanordnung umfasst zusätzlich oder alternativ wenigstens eine Verschleißschutzschicht, die mit dem Gehäuse oder mit der äußeren Leitschaufelfahne verbunden ist. Alternativ ist wenigstens eine Verschleißschutzschicht mit dem Gehäuse und wenigstens eine weitere Verschleißschutzschicht mit der äußeren Leitschaufelfahne verbunden. Die eine oder mehrere Verschleißschutzschicht(en) bildet oder bilden den zweiten Spalt zumindest bereichsweise aus.

Das erfindungsgemäße Verfahren zum Aufbringen einer zerreibbaren Verschleißschutzschicht auf einen Innenring und/oder ein Gehäuse einer Verschleißschutzanordnung umfasst den Schritt des Aufbringens der zerreibbaren Verschleißschutzschicht mittels eines thermischen Spritzverfahrens.

Das erfindungsgemäße Verfahren zum Aufbringen einer schleifenden Verschleißschutzschicht auf eine innere und/oder auf eine äußere Leitschaufelfahne einer Verschleißschutzanordnung umfasst einen der drei im Folgenden genannten Schritte. Die schleifende Verschleißschutzschicht wird entweder mittels eines thermischen Spritzverfahrens oder mittels eines physikalischen Gasphasenabscheidungsverfahren (PVD) oder mittels eines chemischen Gasphasenabscheidungsverfahren (CVD) aufgebracht.

Der erfindungsgemäße Verdichter einer Strömungsmaschine umfasst wenigstens eine erfindungsgemäße Verschleißschutzanordnung.

Bei allen vorstehenden und folgenden Ausführungen ist der Gebrauch des Ausdrucks "kann sein" bzw. "kann haben" usw. synonym zu "ist vorzugsweise" bzw. "hat vorzugsweise" usw. zu verstehen und soll erfindungsgemäße Ausführungsformen erläutern.

Wann immer hierin Zahlenworte genannt werden, so versteht der Fachmann diese als Angabe einer zahlenmäßig unteren Grenze. Sofern dies zu keinem für den Fachmann erkennbaren Widerspruch führt, liest der Fachmann daher beispielsweise bei der Angabe "ein" oder "einem" stets "wenigstens ein" oder "wenigstens einem" mit. Dieses Verständnis ist ebenso von der vorliegenden Erfindung mit umfasst wie die Auslegung, dass ein Zahlenwort wie beispielsweise "ein" alternativ als "genau ein" gemeint sein kann, wo immer dies für den Fachmann erkennbar technisch möglich ist. Beides ist von der vorliegenden Erfindung umfasst und gilt für alle hierin verwendeten Zahlenworte.

Vorteilhafte Weiterentwicklungen der vorliegenden Erfindung sind jeweils Gegenstand von Unteransprüchen und Ausführungsformen.

Erfindungsgemäße beispielhafte Ausführungsformen können eines oder mehrere der im Folgenden genannten Merkmale aufweisen.

Im Folgenden werden als Strömungsmaschinen rein beispielhaft insbesondere Gasturbinen beschrieben, ohne jedoch Strömungsmaschinen auf Gasturbinen beschränken zu wollen. Die Strömungsmaschine kann insbesondere eine axiale Strömungsmaschine sein. Die Gasturbine kann insbesondere eine axiale Gasturbine, beispielsweise eine Fluggasturbine, sein.

Der Begriff "Verstellbereich" der Leitschaufel, wie er hierin verwendet wird, bezeichnet einen Bereich, der einen Leitschaufelabschnitt und einen Gehäuseabschnitt und/ oder einen Innenringabschnitt umfasst, in dem die Leitschaufel verstellbar oder drehbar angeordnet ist. Der Verstellbereich der Leitschaufel im Bereich des Gehäuses umfasst somit den Gehäuseabschnitt als auch den Leitschaufelabschnitt (insbesondere die Leitschaufelfahne), der diesen Bereich überdeckt oder abdeckt. Die Leitschaufelfahne kann durch einen Spalt vom Gehäuseabschnitt getrennt sein oder in Kontakt mit dem Gehäuseabschnitt stehen. Analog ist der Verstellbereich der Leitschaufel im Bereich des Innenrings zu verstehen.

In einigen erfindungsgemäßen Ausführungsformen ist die wenigstens eine Verschleißschutzschicht mit dem Innenring oder mit der inneren Leitschaufelfahne trennbar verbunden. Alternativ kann die wenigstens eine Verschleißschutzschicht mit dem Innenring und wenigstens eine weitere Verschleißschutzschicht mit der inneren Leitschaufelfahne trennbar verbunden sein.

In manchen erfindungsgemäßen Ausführungsformen umfasst die erfindungsgemäße Verschleißschutzanordnung zusätzlich oder alternativ wenigstens eine Verschleißschutzschicht, die mit dem Gehäuse oder mit der äußeren Leitschaufelfahne trennbar verbunden ist. Alternativ kann wenigstens eine Verschleißschutzschicht mit dem Gehäuse und wenigstens eine weitere Verschleißschutzschicht mit der äußeren Leitschaufelfahne trennbar verbunden sein.

Eine trennbare Verbindung der Verschleißschutzschicht mit einem Grundmaterial ist beispielsweise eine Verbindung, bei der die Verschleißschutzschicht ausgetauscht oder ausgewechselt werden kann, etwa wenn sie beschädigt oder verschlissen ist. Eine trennbare Verbindung kann eine geklebte Verbindung sein, die mittels Wärme oder mittels Lösungsmittel wieder getrennt und anschließend neu aufgebracht werden kann. Ebenso kann eine trennbare Verbindung eine formschlüssige Verbindung sein, die zusätzlich mechanisch fixiert werden kann.

In gewissen erfindungsgemäßen Ausführungsformen wird eine trennbare Verschleißschutzschicht bei dem Trennvorgang vollständig oder teilweise zerstört. Beispielsweise kann eine aufgespritzte Verschleißschutzschicht, die als Spritzbelag bezeichnet werden kann, mechanisch und/oder chemisch getrennt oder entfernt werden. Ein mechanisches Trennen kann beispielsweise mittels Abdrehen oder Abfräsen erzielt werden. Ein chemisches Trennen kann mittels chemischem Lösen oder Auslösen der Verschleißschutzschicht erfolgen.

Die Leitschaufel ist im Verstellbereich drehbar, insbesondere in einem vorgegebenen Winkelbereich drehbar angeordnet. Die Leitschaufel ist insbesondere entlang seiner Längsachse drehbar angeordnet. Die Längsachse kann durch die beiden Lagerzapfen an den Enden der Leitschaufel verlaufen.

In bestimmten erfindungsgemäßen Ausführungsformen ist die Verschleißschutzschicht ein Belag.

In gewissen erfindungsgemäßen Ausführungsformen ist die Verschleißschutzschicht zum Schutz eines Grundmaterials vorgesehen, welches unterhalb der Schutzschicht angeordnet sein kann. Das Grundmaterial kann beispielsweise das Material des Gehäuses der Strömungsmaschine, des Innenrings der Leitschaufel oder der Leitschaufel sein oder dieses aufweisen. Die Verschleißschutzschicht kann zum Verhindern einer Bauteilbeschädigung, welches aus dem Grundmaterial gefertigt wurde, vorgesehen sein.

In manchen erfindungsgemäßen, beispielhaften Ausführungsformen ist die Verschleißschutzschicht trennbar mit einem Grundmaterial, beispielsweise des Innenrings oder des Gehäuses, verbunden. Infolge einer betriebsbedingten Abnutzung, einer temporären Überlastung oder anderer Vorgänge kann eine Reparatur der Verschleißschutzschicht notwendig werden. Mittels der erfindungsgemäßen Verschleißschutzanordnung kann die Verschleißschutzschicht mittels Trennen von dem Grundmaterial entfernt werden. Anschließend kann eine Neubeschichtung mit einer neuen Verschleißschutzschicht erfolgen. Der ursprüngliche geometrische Zustand der Anordnung in der Strömungsmaschine, beispielsweise des Ringraums mit dem Gehäuse und dem Innenring, kann vorteilhaft wiederhergestellt werden. Ein Austauschen des gesamten Innenrings oder eines Gehäusesegments kann vermieden werden. Dadurch kann der Reparaturvorgang vorteilhaft vereinfacht werden, indem die Reparaturzeit verkürzt und die Materialkosten und Ersatzteilkosten verringert werden können.

Im Stand der Technik kann die Reparatur eines beschädigten Gehäuses oder Innenrings ohne erfindungsgemäßer Verschleißschutzschicht beispielsweise mittels zwei verschiedener Techniken durchgeführt werden. Die erste Technik umfasst ein sogenanntes Ausblenden der beschädigten Bereiche oder Stellen. Mittels dem Ausblenden wird oft nicht der geometrische Originalzustand des Ringraums wiederhergestellt. Dies kann zu Spaltvergrößerungen an den Leitschaufelfahnen führen. Spaltvergrößerungen können einen negativen Einfluss auf den Wirkungsgrad und die Pumpgrenze der Strömungsmaschine, ausgestaltet beispielsweise als Verdichter, haben. Die zweite Technik umfasst ein Aufbringen einer metallischen Schicht mit einer nachfolgenden Nachbearbeitung, beispielsweise um vorgegebene geometrische Toleranzen einzuhalten. Das Aufbringen einer metallischen Schicht mit einer nachfolgenden Nachbearbeitung kann zu erhöhten Kosten durch eine aufwendige Reparatur und Nacharbeit führen. Gegenüber beiden Techniken aus dem Stand der Technik weist die erfindungsgemäße Verschleißschutzanordnung mit trennbaren Verschleißschutzschichten eine vorteilhaft einfache, schnelle und kostengünstige Möglichkeit zur Reparatur mittels einer Erneuerung der Verschleißschutzschicht auf.

In einigen erfindungsgemäßen, beispielhaften Ausführungsformen ist die Verschleißschutzschicht mit dem Innenring verbunden, so dass eine Leitschaufel oder eine Schaufelfahne (ein radial inneres oder äußeres Ende der Schaufel), die bei dieser Ausführung keine Schutzschicht aufweist, in bestimmten Betriebspunkten in die Verschleißschutzschicht eingreift oder sich eingräbt. Ein derartiger Betriebspunkt kann etwa einen sehr hohen oder einen sehr niedrigen Volumenstrom durch die Strömungsmaschine vorsehen, so dass die Verstellwinkel der Leitschaufel in dem einen oder anderen Endbereich des Verstellbereichs der Leitschaufel positioniert sind. Ebenso kann beispielsweise die Gehäuseinnenseite als auch die äußere Leitschaufelfahne eine Verschleißschutzschicht aufweisen. Weitere Kombinationen sind gleichfalls möglich.

In manchen erfindungsgemäßen Ausführungsformen ist die Verschleißschutzschicht kein Einlaufbelag. Ein Einlaufbelag kann dafür vorgesehen sein, Aussparungen zur Ausbildung eines Spaltes zwischen der Leitschaufel und dem Gehäuse und/ oder dem Innenring herauszuarbeiten.

In manchen erfindungsgemäßen Ausführungsformen ist die Verschleißschutzschicht auf das Grundmaterial geklebt, gelötet, geschweißt, thermisch aufgespritzt und/ oder formschlüssig mit dem Grundmaterial verbunden.

In bestimmten erfindungsgemäßen Ausführungsformen ist die Verschleißschutzschicht zerreibbar oder schleifend. Die Verschleißschutzschicht kann ein Material oder mehrere Materialien aufweisen, die zerreibbar oder schleifend sind.

Bei einem Reibvorgang kann ein Werkzeug oder ein Bauteil unter Anwendung eines bestimmten mechanischen Drucks an einem weiteren Bauteil hin und her bewegt und dabei von dem weiteren Bauteil Material abgetragen werden. In einigen erfindungsgemäßen Ausführungsform kann die Leitschaufel (genauer die Leitschaufelfahne) an der Verschleißschutzschicht reiben und dabei Material von der Verschleißschutzschicht abtragen. Mit anderen Worten wird die Verschleißschutzschicht von der Leitschaufel in den Kontaktbereichen zerrieben. Dieser Abtrag kann ein spanender Abtrag sein.

In gewissen erfindungsgemäßen, beispielhaften Ausführungsformen weist eine zerreibbare Verschleißschutzschicht eine poröse Metallmatrix auf. Eine poröse Metallmatrix kann als Metallmatrix mit Poren oder mit einer Porenstruktur bezeichnet werden. Die Porenstruktur kann offen, geschlossen oder teilweise offen und geschlossen sein.

In einigen erfindungsgemäßen, beispielhaften Ausführungsformen umfasst die Metallmatrix wenigstens Aluminium, eine Aluminium-Silizium-Legierung, Nickel oder eine Nickel-Chrom-Aluminium-Legierung.

In manchen erfindungsgemäßen, beispielhaften Ausführungsformen ist der Porenanteil der porösen Metallmatrix zwischen 3% und 35%. Eine Metallmatrix mit einem Porenanteil von 35% kann als offenporiger gegenüber einer Metallmatrix mit einem Porenanteil von 3% bezeichnet werden. Eine offenporige Metallmatrix kann weniger Widerstand gegen ein Zerreiben aufweisen als eine weniger offenporige Metallmatrix.

In bestimmten erfindungsgemäßen, beispielhaften Ausführungsformen ist die Verschleißschutzschicht schleifend. Bei einem Schleifvorgang kann ein Schleifmittel ein zweites Material schleifend bearbeiten. Dabei wird in der Regel das zweite Material von dem Schleifmittel abgetragen.

In bestimmten erfindungsgemäßen, beispielhaften Ausführungsformen ist die Schichtdicke der zerreibbaren Verschleißschutzschicht zwischen 0,1mm und 2mm.

In gewissen erfindungsgemäßen, beispielhaften Ausführungsformen umfasst eine schleifende Verschleißschutzschicht ein carbidisches, nitridisches und/oder carbonitridisches Material. Als Carbide kann eine Stoffgruppe chemischer Verbindungen bezeichnet werden, die das Element Kohlenstoff C und ein weiteres Element E aufweisen. Allgemein kann ein Carbid mit der Formel EₓC_{y} beschrieben werden. Ein allgemeines Beispiel für ein Carbid ist das Titancarbid oder das Wolframcarbid. Ein nitridisches Material weist anstatt Kohlenstoff C im carbidischen Material das Element Stickstoff N auf. Ein carbonitridisches Material weist sowohl Kohlenstoff C als auch Stickstoff N auf.

In einigen erfindungsgemäßen, beispielhaften Ausführungsformen weist die schleifende Verschleißschutzschicht eine Materialzusammensetzung der Form (M1)ₐ(M2)_{b}N_{c}C_{d} auf. N bezeichnet Stickstoff und C bezeichnet Kohlenstoff. Die Kürzel M1 und M2 bezeichnen wenigstens eines der Metalle Aluminium, Titan, Zirkonium, Chrom oder Wolfram. Die stöchiometrischen Faktoren a, b, c, d weisen einen der Werte Null, Eins, Zwei, Drei oder Vier auf. Wenigstens einer der Faktoren a, b, c, d ist größer als Null. Wenn c und d größer als Null sind, handelt es sich beispielsweise um ein carbonitridisches Material.

In manchen erfindungsgemäßen, beispielhaften Ausführungsformen weist die schleifende Verschleißschutzschicht eine oder mehrere Schichten auf, wobei mehrere Schichten gleiche oder unterschiedliche Materialzusammensetzungen der Form (M1)ₐ(M2)_{b}N_{c}C_{d} aufweisen können. Eine einschichtige Verschleißschutzschicht kann als Monolayer bezeichnet werden, eine mehrschichtige Verschleißschutzschicht als Mulitlayer.

In bestimmten erfindungsgemäßen, beispielhaften Ausführungsformen umfasst die schleifende Verschleißschutzschicht wenigstens eine Metallmatrix mit eingelagerten Partikeln. Ein oder mehrere Metalle der Metallmatrix können Aluminium, Titan, Zirkonium, Chrom oder Wolfram umfassen oder aufweisen. Die Partikel können eine Materialzusammensetzung der Form (M1)ₐ(M2)_{b}N_{c}C_{d} aufweisen, wobei N Stickstoff und C Kohlenstoff ist, und M1 und M2 wenigstens Aluminium, Titan, Zirkonium, Chrom oder Wolfram umfasst. Die stöchiometrischen Faktoren a, b, c, d weisen einen der Werte Null, Eins, Zwei, Drei oder Vier auf, wobei wenigstens einer der Faktoren a, b, c, d größer als Null ist.

In manchen erfindungsgemäßen Ausführungsformen ist es nicht möglich, im Verstellbereich der Leitschaufel eine schleifende Verschleißschutzschicht, auf einer radial äußeren Leitschaufelfahne, gegen eine schleifende Verschleißschutzschicht im Gehäuseabschnitt des Verstellbereichs gegeneinander zu bewegen.

In einigen erfindungsgemäßen Ausführungsformen ist es nicht möglich, im Verstellbereich der Leitschaufel eine schleifende Verschleißschutzschicht, auf einer radial inneren Leitschaufelfahne, gegen eine schleifende Verschleißschutzschicht im Innenringabschnitt des Verstellbereichs gegeneinander zu bewegen.

In der folgenden Tabelle werden bestimmte erfindungsgemäße Ausführungsformen für bevorzugte Kombinationen von Verschleißschutzschichten, die mit der Laufschaufel, dem Gehäuse und/ oder dem Innenring verbunden sind, zusammengefasst.

### Legende:

"++" - bevorzugte Kombination
"+" - mögliche Kombination
"--" - keine bevorzugte Kombination

| | | **Leitschaufel** | | |
|---|---|---|---|---|
| | | ohne Verschleißschutzschicht | mit Verschleißschutzschicht | |
| | | | zerreibbar | schleifend |
| **Gehäuse und/ oder Innenring** | zerreibbare Verschleißschutzschicht | ++ | + | ++ |
| | schleifende Verschleißschutzschicht | + | + | -- |

Im Folgenden werden rein exemplarisch Beispiele für mögliche Materialien für die Verschleißschutzschichten, zerreibbar oder schleifend, und für die Leitschaufeln angegeben. Die Verschleißschutzschichten und die Leitschaufeln können vollständig, teilweise oder gar nicht diese Materialien aufweisen. Mögliche Materialien sind jedoch nicht auf diese exemplarischen Beispiele beschränkt.

Rein exemplarische Materialien für die verstellbaren Leitschaufeln:
- Titan (Ti), z.B. Ti64, Titanlegierungen
- Stahl (z.B. mit den Legierungsbestandteilen X 4 Ni Cr Ti 25 15 oder X 5 Ni Cr Ti 26 15)
- Nickel-Chrom-Legierungen

Rein exemplarische Materialien oder Ausgestaltungen für zerreibbare Verschleißschutzschichten:
- Metallmatrix mit Poren (als zweiphasige Verschleißschutzschicht)
- Metallmatrix mit Poren und einem Festschmierstoff (als dreiphasige Verschleißschutzschicht)
- Metallmatrix (synonym: metallische Matrix), aufweisend beispielsweise Aluminium (Al), Aluminium-Silizium (AlSi), Nickel (Ni), Nickel-Chrom-Aluminium-Legierung und/oder weiteren Materialien
- Porenanteil der Metallmatrix mit Poren zwischen 3% und 35%
- Festschmierstoff, aufweisend beispielsweise Graphit, Bornitrid (BN), Bentonit
- Schichtdicke der zerreibbaren Verschleißschutzschichten zwischen 0,1 mm und 2,0 mm
- Epoxidharze
- Aluminium/Silizium (AlSi)/ Polyester

Rein exemplarische Materialien oder Ausgestaltungen für schleifende Verschleißschutzschichten:
- Einschichtige (Monolayer) oder mehrschichtige (Multilayer) Verschleißschutzschichten (eine Verschleißschutzschicht kann als Belag bezeichnet werden)
- Multilayer können homogene oder inhomogene (unterschiedliche) Materialzusammensetzungen aufweisen
- Monolayer oder Multilayer können carbidische, nitridische und/oder carbonitridische Hartstoffphasen aufweisen
- Carbidische, nitridische oder carbonitridische Hartstoffphasen können die folgende Materialzusammensetzung aufweisen: (M1)ₐ(M2)_{b}N_{c}C_{d}, mit folgender Legende:
   ▪ N: Stickstoff; C: Kohlenstoff
   ▪ M1, M2: Metalle aus der Gruppe Aluminium, Titan, Zirkonium, Chrom, Wolfram
   ▪ a, b, c, d: stöchiometrische Faktoren, die die Werte Null, Eins, Zwei, Drei oder Vier aufweisen, wobei wenigstens einer der Faktoren a, b, c, d größer als Null ist.
- Exemplarisches Beispiel für eine Materialzusammensetzung der Form (M1)ₐ(M2)_{b}N_{c}C_{d} (ohne stöchiometrischer Angabe): Titancarbonitrid (Ti(C,N))
- Monolayer oder Multilayer können ein homogenes Mehrphasensystem sein, umfassend:
   ▪ eine duktile Metallmatrix mit wenigstens einem Metall aus der Gruppe Aluminium (Al), Titan (Ti), Zirkonium (Zr), Cobalt (Co), Nickel (Ni), Eisen (Fe), Chrom (Cr); und
   ▪ eingelagerte Hartstoffpartikel, beispielsweise carbidische, nitridische oder carbonitridische Hartstoffpartikel mit der Materialzusammensetzung (M1)ₐ(M2)_{b}N_{c}C_{d}, (N: Stickstoff; C: Kohlenstoff; M1, M2: Metalle aus der Gruppe Aluminium, Titan, Zirkonium, Chrom, Wolfram; a, b, c, d:
      stöchiometrische Faktoren mit den Werten Null, Eins, Zwei, Drei oder Vier.
- Aluminiumoxid Al₂O₃
- Zirkoniumoxid

Rein exemplarisch kann die oben angegebene Tabelle folgende bevorzugte Materialkombinationen aufweisen:

### Legende:

### Beispiele angegeben: bevorzugte Kombination

"--" - keine bevorzugte Kombination

| | | **Leitschaufel** | | |
|---|---|---|---|---|
| | | ohne Verschleißschutzschicht | mit Verschleißschutzschicht | |
| | | | zerreibbar | schleifend |
| **Gehäuse und/oder Innenring** | zerreibbare Verschleißschutzschicht | Leitschaufel: Ti/Ti-Legierung/Stahl | | Schutzschicht der Leitschaufel: Monolayer oder Multilayer mit eingelagerten Hartstoffpartikeln (M1)ₐ(M2)_{b}N_{c}C_{d}, |
| | | Schutzschicht des Gehäuses und/oder des Innenrings: Metallmatrix mit Poren, optional mit einem Festschmierstoff | | |
| | | | | Schutzschicht des Gehäuses und/oder des Innenrings: Metallmatrix mit Poren, optional mit einem Festschmierstoff |
| | schleifende Verschleißschutzschicht | | | -- |

Manche oder alle erfindungsgemäßen Ausführungsformen können einen, mehrere oder alle der oben und/oder im Folgenden genannten Vorteile aufweisen.

Mit der erfindungsgemäßen Verschleißschutzanordnung kann ein direkter Kontakt einer, beschichteten oder nicht beschichteten, Schaufelfahne mit dem Grundmaterial oder Basismaterial des Innenrings und/ oder des Gehäuses vorteilhaft vermieden werden. Das Grundmaterial oder Basismaterial des Innenrings und/ oder des Gehäuses ist das Material oder der Werkstoff, auf den eine Verschleißschutzschicht aufgebracht werden kann. Mittels der erfindungsgemäßen Verschleißschutzanordnung kann eine Beschädigung des Grundmaterials des Innenrings und/ oder des Gehäuse verhindert, und dadurch erreicht werden, dass nur die Verschleißschutzschicht (synonym: der Belag) gegebenenfalls repariert und/oder erneuert werden muss. Dies hat den Vorteil, dass Reparaturkosten, Ausfallzeiten und Ersatzteilkosten reduziert werden können.

Die Spalte zwischen der Leitschaufel einerseits und dem Gehäuse und/ oder dem Innenring andererseits werden üblicherweise derart konstruktiv ausgelegt, dass im Betriebszustand kein Kontakt zwischen der Leitschaufel und dem Gehäuse und/ oder dem Innenring auftritt. Mittels der erfindungsgemäßen Verschleißschutzanordnung mit der Verschleißschutzschicht können nun Spalte enger ausgelegt werden, da ein Kontakt mit der Verschleißschutzanordnung zu keinen größeren Folgeschäden und entsprechenden Kosten (wie oben beschrieben) führen. Dies führt zu einer vorteilhaften Erhöhung des Wirkungsgrad der Strömungsmaschine und einer Erhöhung der Pumpgrenze.

Nach dem Stand der Technik werden mögliche Kontakte und Eingrabungen der Leitschaufeln in das Gehäuse und/ oder in den Innenring durch Verblenden repariert. Dies kann permanente Spaltvergrößerungen an der Schaufelfahne zur Folge haben. Mittels einer Erneuerung der erfindungsgemäßen Verschleißschutzschicht kann der ursprüngliche, engere Spalt wieder erzielt werden. Dies kann vorteilhaft zu einer Wirkungsgrad- und einer Pumpgrenzverbesserung während einer Überholung (Wartung) der Strömungsmaschine führen, wobei die Strömungsmaschine als Flugtriebwerk oder als Teil eines Flugtriebwerks ausgeführt sein kann.

Die vorliegende Erfindung wird im Folgenden anhand der beigefügten Zeichnungen, in welcher identische Bezugszeichen gleiche oder ähnliche Bauteile bezeichnen, exemplarisch erläutert. In den jeweils schematisch vereinfachten Figuren gilt:
- **Fig. 1**: zeigt eine verstellbare Leitschaufel in einer Strömungsmaschine gemäß dem Stand der Technik;
- **Fig. 2**: zeigt eine erfindungsgemäße Verschleißschutzanordnung mit einer mit einem Innenring verbundenen Verschleißschutzschicht;
- **Fig. 3**: zeigt eine perspektivische Darstellung der erfindungsgemäßen Verschleißschutzanordnung aus Fig. 2;
- **Fig. 4**: zeigt eine weitere perspektivische Darstellung der erfindungsgemäßen Verschleißschutzanordnung aus Fig. 2;
- **Fig. 5**: zeigt eine erfindungsgemäße Verschleißschutzanordnung mit einer mit einem Gehäuse verbundenen Verschleißschutzschicht;
- **Fig. 6**: zeigt eine weitere Ansicht der erfindungsgemäßen Verschleißschutzanordnung aus Fig. 5;
- **Fig. 7**: zeigt eine perspektivische Ansicht der erfindungsgemäßen Verschleißschutzanordnungen aus den Fig. 2 bis 6;
- **Fig. 8**: zeigt eine erfindungsgemäße Verschleißschutzanordnung mit einer Verschleißschutzschicht an einem radial äußeren Ende der Leitschaufel;
- **Fig. 9**: zeigt eine perspektivische Ansicht der erfindungsgemäßen Verschleißschutzanordnung aus Fig. 8;
- **Fig. 10**: zeigt eine erfindungsgemäße Verschleißschutzanordnung mit einer Verschleißschutzschicht an einem radial inneren Ende der Leitschaufel; und
- **Fig. 11**: zeigt eine Detailansicht der Verschleißschutzschicht am radial inneren Ende der Leitschaufel.

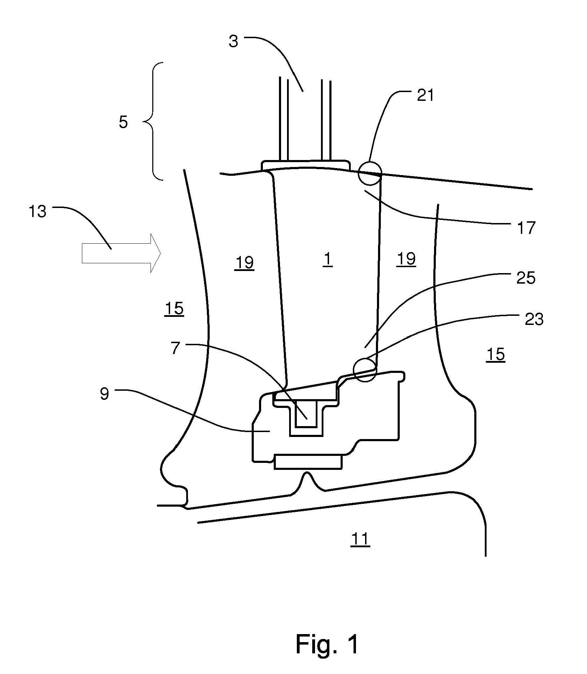

**Fig. 1** zeigt eine verstellbare Leitschaufel 1 in einer Strömungsmaschine gemäß dem Stand der Technik. Die Leitschaufel 1 ist mit einem Außenzapfen 3 in einem Gehäuse 5 und mit einem Innenzapfen 7 in einem Innenring 9 der Strömungsmaschine drehbar gelagert. Ein Rotor 11 ist mit stromauf und stromab (in Hauptströmungsrichtung 13 betrachtet) angeordneten Laufrädern 15 verbunden.

In bestimmten Betriebspunkten der Strömungsmaschine kann es bei einem Verstellen oder Drehen der Leitschaufel 1 zu einem Kontakt der Leitschaufel 1 mit dem Gehäuse 5 und/ oder mit dem Innenring 9 kommen. Ein derartiger Kontakt kann zu Beschädigungen des Gehäuse 5 und/ oder des Innenrings 9 führen. Derartige Beschädigungen können zu Eingrabungen, beispielsweise mit einer sichelförmigen Kontur, führen. Die Beschädigungen können es erforderlich machen, dass zumindest die beschädigten Gehäusebereiche und/ oder der beschädigte Innenring 9 repariert oder ausgetauscht werden müssen. Dies kann zu Ausfallzeiten, hohen Ausfallkosten, Wartungskosten und Ersatzteilkosten führen.

In Fig. 1 können derartige Beschädigungen im Bereich des Hauptdurchströmungskanal 19, der im Folgenden als Strömungskanal 19 bezeichnet wird, des Gehäuses 5 auftreten, verursacht durch die radial äußere Schaufelfahne 17. Dieser Bereich wird als Gehäusebereich 21 zwischen der äußeren Schaufelfahne 17 und dem Gehäuse 5 in Fig. 1 dargestellt.

Analog zu den beschriebenen Beschädigungen im Gehäusebereich 21 kann ein Kontakt einer inneren Schaufelfahne 25 am Innenring 9 in einem Innenringbereich 23 zwischen der inneren Schaufelfahne 25 und dem Innenring 9 auftreten. Diese Beschädigungen des Innenrings 9 können es ebenfalls erforderlich machen, dass dieser repariert oder ausgetauscht werden muss.

Die Beschädigungen können sichelförmige Eingrabungen aufweisen.

Die Anordnung gemäß dem Stand der Technik in Fig. 1 ist insbesondere eine Anordnung in Hochdruckverdichtern von Strömungsmaschinen. Die beschriebenen Beschädigungen können jedoch auch in anderen Bereichen von verstellbaren Schaufeln in Strömungsmaschinen auftreten, beispielsweise im Bereich von Turbinen, von Niederdruckverdichtern, in Fans (Gebläse oder Bläser) oder ähnlichem.

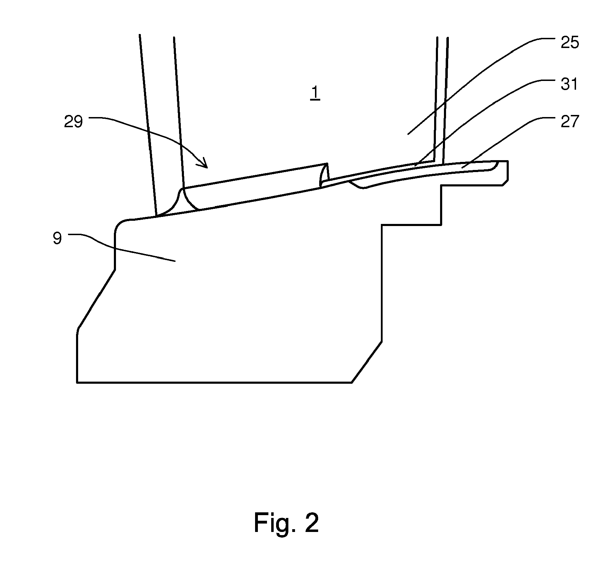

**Fig. 2** zeigt eine erfindungsgemäße Verschleißschutzanordnung mit einer mit dem Innenring 9 verbundenen Verschleißschutzschicht 27. Die verstellbare Leitschaufel 1 ist in dem Innenring 9 mittels einer Lagerung 29 drehbar gelagert. Zwischen dem radial inneren Ende der Leitschaufel 1 (der inneren Schaufelfahne 25) und der Verschleißschutzschicht 27 ist ein Spalt 31 dargestellt. Dieser Spalt 31 wird in der Regel konstruktiv klein oder schmal ausgelegt, um Strömungsverluste (sogenannte Spaltverluste) zu minimieren. Aufgrund dieser Spaltminimierung kann in bestimmten Betriebspunkten der Strömungsmaschine bei einem Verstellen oder Drehen der Leitschaufel 1 ein Kontakt der Leitschaufel 1 mit der Verschleißschutzschicht 27 auftreten. Ein Kontakt wird insbesondere durch mögliche sogenannte Ovalitäten (Unrundheiten) der Lagerung oder Führung der Leitschaufel 1 im Innenring 9 hervorgerufen oder verstärkt.

Die Ovalitäten können aufgrund verschiedener Ursachen entstehen. Beispielsweise können thermische Verformungen im Betrieb der Strömungsmaschine oder Exzentritäten der inneren Lagerung 29 und/ oder der äußeren Lagerung (insbesondere Exzentritäten der Lagerbuchsen oder der Zapfen 3, 7 zueinander) Ovalitäten verursachen. Alternativ oder zusätzlich können Druckkräfte und/ oder Schub- oder Manöververformungen zu Ovalitäten führen.

Weiterhin kann ein Kontakt der Leitschaufel 1 mit der Verschleißschutzschicht 27 verschleißbedingt auftreten. Beispielsweise kann ein Kontakt aufgrund thermischer Belastungen und/ oder häufiger Drehungen der verstellbaren Leitschaufel 1 auftreten. In weiteren Ausführungsformen können die Zapfen 3, 7 in Buchsen geführt werden, die jeweils mit dem Gehäuse und/ oder mit dem Innenring verbunden sind. Diese Buchsen können verschleißen, insbesondere wenn die Buchsen aus einem reiboptimierten, weicheren Material gegenüber dem Gehäusematerial und/ oder dem Innenringmaterial hergestellt sind.

Ohne der erfindungsgemäßen Verschleißschutzschicht 27 kann, wie in Fig. 1 dargestellt, ein direkter Kontakt der inneren Leitschaufelfahne 25 mit dem Innenring 9 auftreten. Dies könnte zu einer Beschädigung des Innenring 9 bis hin zu einer möglichen Reparatur und einem Austausch ganzer Bauteile führen können. Die erfindungsgemäße Verschleißschutzschicht 27 kann dagegen derart ausgelegt werden, dass nur die Verschleißschutzschicht 27 selbst (also nicht die Leitschaufelfahne 25) abgerieben, abgeschliffen oder abgetragen wird. Ein derartiger Abtrag kann sich als Eingrabung oder Vertiefung mit sichelförmigen Kontur (aufgrund der Drehung der Schaufelfahne 25 in die Verschleißschutzschicht 27 hinein) ausbilden.

Je nach Einsatzdauer der Strömungsmaschine und Zustand der Verschleißschutzschicht 27 (beispielsweise bei einem vergrößerten Spalt 31 zwischen der Schaufelfahne 25 und der Verschleißschutzschicht 27) kann die Verschleißschutzschicht 27 ausgetauscht oder gewechselt werden, ohne größere Bauteile oder Reparaturen an der Schaufel 1 oder dem Innenring 9 durchführen zu müssen. Damit können Reparaturkosten reduziert werden. Weiterhin können

Ausfallzeiten, hohen Ausfallkosten, Wartungskosten und Ersatzteilkosten reduziert werden.

Die Materialpaarung zwischen der inneren Schaufelfahne 25 und der Verschleißschutzschicht 27 sollte derart gewählt werden, dass ein Zerreiben oder Schleifen der Verschleißschutzschicht 27 mittels der Schaufelfahne 25 möglich ist. Insbesondere sollte das Material der Schaufelfahne 25 härter sein als das der Verschleißschutzschicht 27.

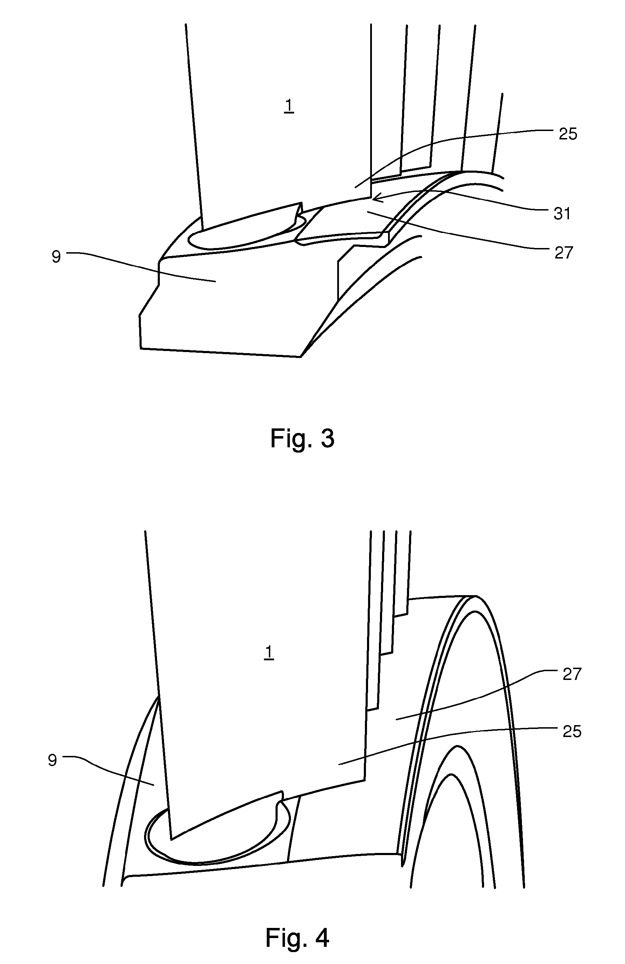

**Fig. 3** und **Fig. 4** zeigen perspektivische Darstellungen der erfindungsgemäßen Verschleißschutzanordnung aus Fig. 2. Auf dem Umfang des Innenrings 9 sind mehrere verstellbare Leitschaufeln 1 angeordnet. Jede Leitschaufel 1 kann in bestimmten Betriebspunkten der Strömungsmaschine bei einem Verstellen oder Drehen der jeweiligen Leitschaufel 1 in Kontakt mit der Verschleißschutzschicht 27 treten. Die Verschleißschutzschichten 27 können mittels Zerreiben oder Abschleifen durch die inneren Schaufelfahnen 25 abgetragen werden.

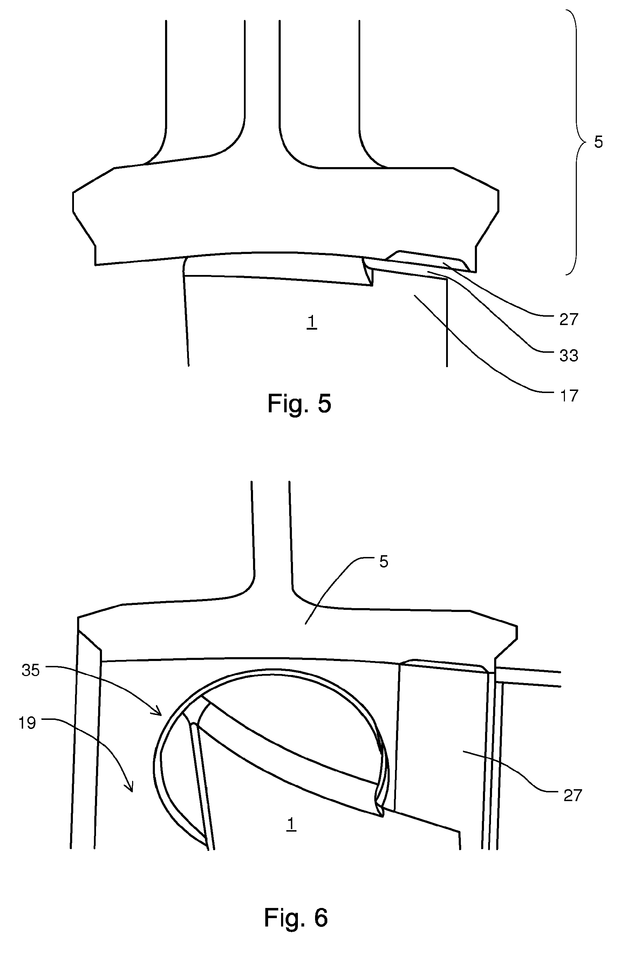

**Fig. 5** zeigt eine erfindungsgemäße Verschleißschutzanordnung mit einer mit dem Gehäuse 5 verbundenen Verschleißschutzschicht 27. Die äußere Schaufelfahne 17 kann Bereiche der Verschleißschutzschicht 27 zerreiben, abschleifen oder abtragen. Die Diskussion zu einem Spalt 33 und den Materialpaarungen gilt analog zu den Beschreibungen zu den Fig. 2 bis 4.

**Fig. 6** zeigt eine weitere Ansicht der erfindungsgemäßen Verschleißschutzanordnung aus Fig. 5. Die Verschleißschutzschicht 27 wird sowohl im Gehäuseschnitt als auch teilweise über dem Umfang auf der Innenseite des Gehäuses 5 im Strömungskanal 19 dargestellt. Weiterhin wird die Lagerung 35 der verstellbaren Leitschaufel 1 im Gehäuse 5 gezeigt.

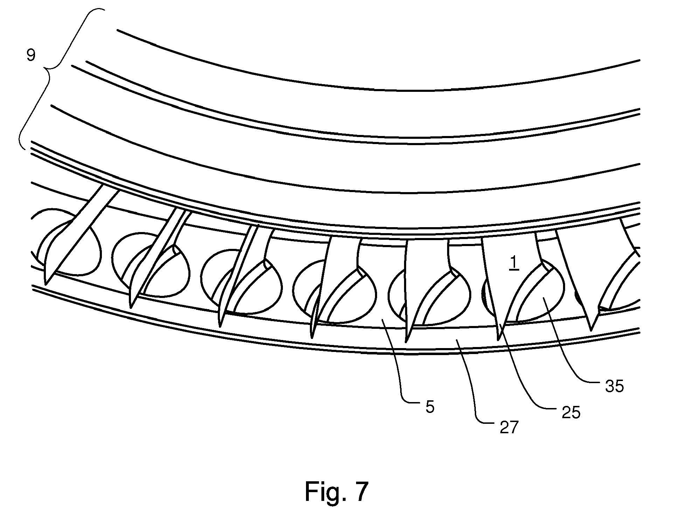

**Fig. 7** zeigt eine perspektivische Ansicht der erfindungsgemäßen
Verschleißschutzanordnungen aus den Fig. 2 bis 6. Die verstellbaren Leitschaufeln 1 sind zwischen dem Innenring 9 und dem Gehäuse 5 angeordnet. Die Lagerung 35 der Leitschaufel 1 im Gehäuse 5 ist in Fig. 7 sichtbar, die Lagerung 29 der Leitschaufel 1 im Innenring 9 verdeckt. Die inneren Schaufelfahnen 25 der Leitschaufeln 1 sind nahe der Verschleißschutzschicht 27 angeordnet und können in bestimmten Betriebspunkten in Kontakt mit der Verschleißschutzschicht 27 treten.

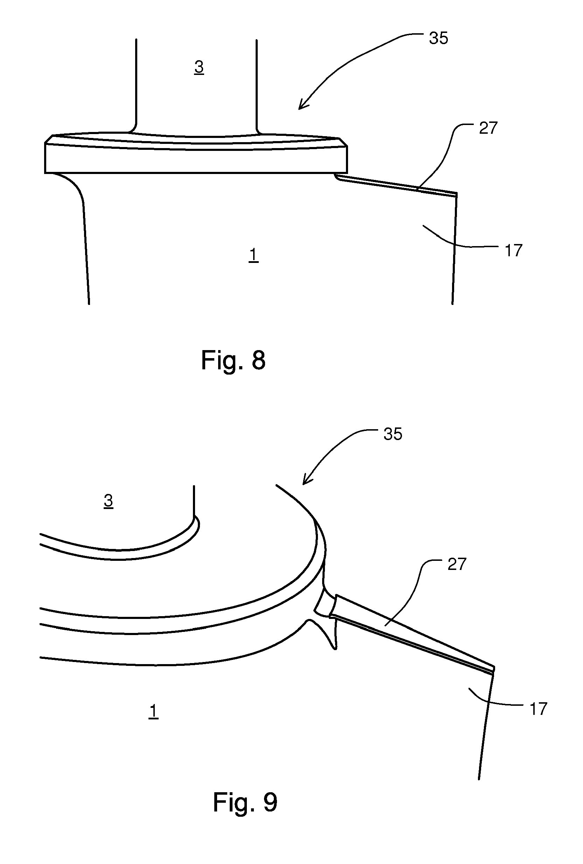

**Fig. 8** zeigt eine erfindungsgemäße Verschleißschutzanordnung mit einer Verschleißschutzschicht 27 an einem radial äußeren Ende der Leitschaufel 1. Die Verschleißschutzschicht 27 ist unmittelbar mit der äußeren Schaufelfahne 17 verbunden. Die Leitschaufel 1 ist mittels der Lagerung 35 und dem Außenzapfen 3 im Gehäuse 5 (in Fig. 8 nicht dargestellt) gelagert.

**Fig. 9** zeigt eine perspektivische Ansicht der erfindungsgemäßen Verschleißschutzanordnung aus Fig. 8.

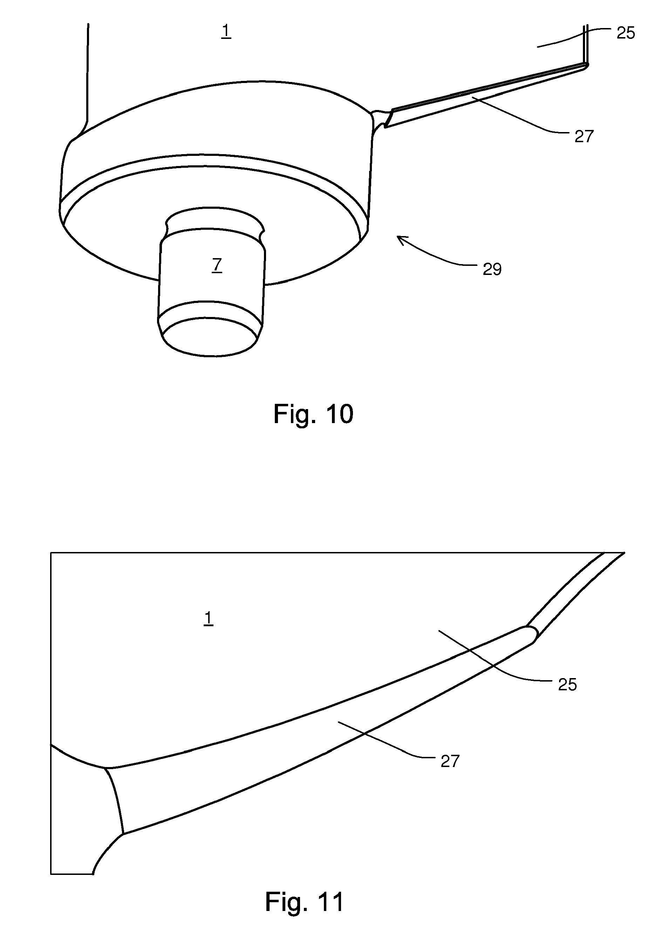

**Fig. 10** zeigt eine erfindungsgemäßen Verschleißschutzanordnung mit einer Verschleißschutzschicht 27 an einem radial inneren Ende der Leitschaufel 1. Analog zu Fig. 8 ist die Verschleißschutzschicht 27 unmittelbar mit der inneren Schaufelfahne 25 verbunden. Die Leitschaufel 1 ist mittels der Lagerung 29 und dem Innenzapfen 7 im Innenring 9 (in Fig. 10 nicht dargestellt) gelagert.

**Fig. 11** zeigt eine Detailansicht aus der Fig. 10 mit der Verschleißschutzschicht 27 am radial inneren Ende der Leitschaufel 1.

### Bezugszeichenliste

- 1: verstellbare Leitschaufel
- 3: Außenzapfen
- 5: Gehäuse
- 7: Innenzapfen
- 9: Innenring
- 11: Rotor
- 13: Strömungsrichtung
- 15: Laufrad
- 17: äußere Schaufelfahne
- 19: Strömungskanal; Hauptdurchströmungskanal
- 21: Gehäusebereich zwischen äußerer Schaufelfahne und Gehäuse
- 23: Innenringbereich
- 25: innere Schaufelfahne
- 27: Verschleißschutzschicht
- 29: Lagerung der verstellbaren Leitschaufel im Innenring
- 31: Spalt zwischen der inneren Schaufelfahne und der Verschleißschutzschicht
- 33: Spalt zwischen der äußeren Schaufelfahne und der Verschleißschutzschicht
- 35: Lagerung der verstellbaren Leitschaufel im Gehäuse

## Patentansprüche

1. Verschleißschutzanordnung für eine Strömungsmaschine, umfassend
- wenigstens eine verstellbare Leitschaufel (1),
- ein Gehäuse (5), in dem die wenigstens eine Leitschaufel (1) verstellbar angeordnet ist,
- einen aus einem metallischen Material hergestellten Innenring (9), in oder an dem die wenigstens eine Leitschaufel (1) verstellbar angeordnet ist,
- einen ersten Spalt (31) zwischen einer inneren Leitschaufelfahne (25) und dem Innenring (9) und einen zweiten Spalt (33) zwischen einer äußeren Leitschaufelfahne (17) und dem Gehäuse (5),
- wenigstens eine Verschleißschutzschicht (27), wobei die Verschleißschutzschicht(en) (27) mit dem Innenring (9) und/oder mit der inneren Leitschaufelfahne (25) verbunden ist oder sind und die Verschleißschutzschicht(en) (27) den ersten Spalt (31) zumindest bereichsweise ausbildet oder ausbilden,
- und/oder die Verschleißschutzschicht(en) (27) mit dem Gehäuse (9) und/oder mit der äußeren Leitschaufelfahne (17) verbunden ist oder sind und die Verschleißschutzschicht(en) (27) den zweiten Spalt (33) zumindest bereichsweise ausbildet oder ausbilden.

2. Verschleißschutzanordnung nach Anspruch 1, wobei die Verschleißschutzschicht (27) zerreibbar oder schleifend ist.

3. Verschleißschutzanordnung nach Anspruch 1 oder 2, wobei eine zerreibbare Verschleißschutzschicht (27) eine poröse Metallmatrix ist oder eine poröse Metallmatrix aufweist.

4. Verschleißschutzanordnung nach Anspruch 3, wobei die Metallmatrix wenigstens Aluminium, eine Aluminium-Silizium-Legierung, Nickel oder eine Nickel-Chrom-Aluminium-Legierung umfasst.

5. Verschleißschutzanordnung nach Anspruch 3 oder 4, wobei der Porenanteil der porösen Metallmatrix zwischen 3% und 35% ist.

6. Verschleißschutzanordnung nach einem Ansprüche 3 bis 5, wobei die zerreibbare Verschleißschutzschicht (27) eine poröse Metallmatrix und einen Festschmierstoff aufweist.

7. Verschleißschutzanordnung nach einem Ansprüche 3 bis 6, wobei die Schichtdicke der zerreibbaren Verschleißschutzschicht (27) zwischen 0,1mm und 2mm ist.

8. Verschleißschutzanordnung nach einem der Ansprüche 2 bis 7, wobei eine schleifende Verschleißschutzschicht (27) ein carbidisches, nitridisches und/oder carbonitridisches Material umfasst.

9. Verschleißschutzanordnung nach einem der Ansprüche 2 bis 8, wobei die schleifende Verschleißschutzschicht (27) eine Materialzusammensetzung der Form (M1)ₐ(M2)_{b}N_{c}C_{d} aufweist, wobei N Stickstoff und C Kohlenstoff ist, und M1 und M2 wenigstens Aluminium, Titan, Zirkonium, Chrom oder Wolfram umfasst, und die stöchiometrischen Faktoren a, b, c, d einen der Werte Null, Eins, Zwei, Drei oder Vier aufweisen, wobei wenigstens einer der Faktoren a, b, c, d größer als Null ist.

10. Verschleißschutzanordnung nach Anspruch 9, wobei die schleifende Verschleißschutzschicht (27) eine oder mehrere Schichten aufweist, wobei mehrere Schichten gleiche oder unterschiedliche Materialzusammensetzungen der Form (M1)ₐ(M2)_{b}N_{c}C_{d} nach Anspruch 9 aufweisen.

11. Verschleißschutzanordnung nach Anspruch 9, wobei die schleifende Verschleißschutzschicht (27) wenigstens eine Metallmatrix mit eingelagerten Partikeln umfasst, wobei die Partikel eine Materialzusammensetzung der Form (M1)ₐ(M2)_{b}N_{c}C_{d} aufweisen, wobei N Stickstoff und C Kohlenstoff ist, und M1 und M2 wenigstens Aluminium, Titan, Zirkonium, Chrom oder Wolfram umfasst, und die stöchiometrischen Faktoren a, b, c, d einen der Werte Null, Eins, Zwei, Drei oder Vier aufweisen, wobei wenigstens einer der Faktoren a, b, c, d größer als Null ist.

12. Verfahren zum Aufbringen einer zerreibbaren Verschleißschutzschicht (27) auf einen Innenring (9) und/oder ein Gehäuse (5) einer Verschleißschutzanordnung nach einem der Ansprüche 2 bis 11, mit dem Schritt:
- Aufbringen der zerreibbaren Verschleißschutzschicht mittels eines thermischen Spritzverfahrens.

13. Verfahren zum Aufbringen einer schleifenden Verschleißschutzschicht (27) auf eine innere (25) und/oder auf eine äußere (17) Leitschaufelfahne einer Verschleißschutzanordnung nach einem Ansprüche 2 bis 11, mit dem Schritt:
- Aufbringen der schleifenden Verschleißschutzschicht mittels eines thermischen Spritzverfahrens; oder
- Aufbringen der schleifenden Verschleißschutzschicht mittels eines physikalischen Gasphasenabscheidungsverfahren (PVD); oder
- Aufbringen der schleifenden Verschleißschutzschicht mittels eines chemischen Gasphasenabscheidungsverfahren (CVD).

14. Verdichter einer Strömungsmaschine mit wenigstens einer Verschleißschutzanordnung nach einem der Ansprüche 1 bis 11.
